# FASCICULE DE BREVET EUROPEEN

(11) **EP 1 803 683 B1**
(45) Date de publication et mention de la délivrance du brevet: **05.10.2011**
(21) Numéro de dépôt: 06127034.4
(22) Date de dépôt: 22.12.2006
(51) Int. Cl.: B81C 1/00

(54) **Procede d'elaboration de nanostructures ordonnées**
Verfahren zur Bearbeitung von geordneten Nanostrukturen
Method of producing ordered nanostructures

(30) Priorité: 27.12.2005 FR 0554108
(43) Date de publication de la demande: 04.07.2007
(73) Titulaire: Commissariat à l'Énergie Atomique et aux Énergies Alternatives, 75015 Paris (FR)
(72) Inventeur: FOURNEL, Frank, 38190, VILLARD BONNOT (FR); MORICEAU, Hubert, 38120, SAINT EGREVE (FR); DEGUET, Chrystel, 38330, SAINT ISMIER (FR)
(74) Mandataire: Poulin, Gérard

(56) Documents cités:
- WO-A-02/29876
- WO-A-02/054466
- FR-A1- 2 766 620

## Description

### DOMAINE TECHNIQUE

La présente invention est relative à la fabrication de nanostructures ordonnées. Ces nanostructures sont utilisables par exemple en microélectronique, en optoélectronique ou en biologie. En particulier, ce type de nanostructures permet de réaliser des réseaux de boites quantiques (quantum dots en anglais) ou des dispositifs électroniques à blocage de Coulomb ou encore des dispositifs émetteurs de lumière.

### ÉTAT DE LA TECHNIQUE ANTÉRIEURE

On connaît par les demandes de brevet FR-A-2 766 620 et FR-A-2 815 121, des méthodes pour former une nanostructuration périodique à la surface d'un substrat, formée d'une alternance de saillies et de creux. Cette nanostructuration est réalisée à partir d'un réseau de défauts cristallins et/ou de champs de contraintes obtenu à l'interface entre deux faces cristallines de substrats assemblées l'une à l'autre. L'enseignement de ces deux demandes de brevets peut être combiné à celui de la demande de brevet FR-A-2 819 099, ce qui permet de contrôler avec une grande précision la périodicité de la nanostructuration et donc la densité des saillies et des creux. Par contre, il est difficile de contrôler de manière précise les dimensions latérales des saillies, leur hauteur ainsi que leur forme et ce de manière homogène à l'échelle du substrat, typiquement de 300 millimètres et plus. Or pour certaines applications, comme par exemple les boites quantiques, il est nécessaire de parfaitement contrôler au moins certains de ces paramètres.

### EXPOSÉ DE L'INVENTION

La présente invention a pour but de proposer un procédé d'élaboration de nanostructures ordonnées sur un substrat, ces nanostructures ayant des dimensions et une localisation déterminées et homogènes à l'échelle du substrat.

Plus précisément la présente invention est un procédé d'élaboration de nanostructures comportant :
une étape de fourniture d'un substrat présentant une couche d'arrêt enterrée et au-dessus de cette couche d'arrêt un film cristallin doté d'un réseau de défauts cristallins et/ou de champs de contraintes et d'une zone cristalline entre les défauts cristallins et/ou les champs de contraintes ,
   - une ou plusieurs étapes d'attaque du substrat, dont une attaque préférentielle soit des défauts cristallins et/ou des champs de contraintes, soit de la zone cristalline entre les défauts cristallins et/ou les champs de contraintes, ces étapes d'attaque permettant de mettre à nu localement la couche d'arrêt et de réaliser des saillies à l'échelle nanométrique, séparées les unes des autres par des creux ayant un fond situé au niveau de la couche d'arrêt, les saillies conduisant aux nanostructures.

Par film on entend une couche dont l'épaisseur est inférieure à 1 micromètre.

Il est possible que le substrat soit obtenu en utilisant les étapes suivantes :
- une étape de collage par adhésion moléculaire d'une face cristalline d'un premier substrat intermédiaire et d'une face cristalline d'un second substrat intermédiaire, ce premier substrat intermédiaire comportant une couche d'arrêt placée sous un film, la face cristalline du premier substrat intermédiaire étant celle du film, le collage étant fait de façon que les faces présentent des réseaux cristallins décalés, et qu'un réseau de défauts cristallins et/ou de champs de contraintes se forme dans une zone cristalline au voisinage de l'interface,
- une étape d'amincissement du second substrat intermédiaire.

En variante, il est possible d'obtenir la structure en reportant, sur un substrat intermédiaire doté de la couche d'arrêt, un film cristallin comportant un tel réseau de défauts cristallins et/ou de champs de contraintes.

Dans un mode de réalisation particulièrement simple, les saillies peuvent matérialiser les nanostructures.

En variante pour augmenter la hauteur des nanostructures, on peut effectuer un traitement complémentaire visant à graver au moins la couche d'arrêt du substrat, les saillies servant de masque lors de ce traitement, les nanostructures étant matérialisées au moins par des tronçons à l'aplomb des saillies, gravés dans la couche d'arrêt du substrat, obtenus lors du traitement complémentaire.

On peut prévoir de recouvrir les saillies d'un matériau apte à renforcer la résistance des saillies lors du traitement complémentaire.

Lorsque le substrat comporte une base sous-jacente à la couche d'arrêt, la gravure du traitement complémentaire peut être arrêtée par la base, ce qui permet de maîtriser la hauteur des nanostructures

Dans un autre mode de réalisation, on peut effectuer, de plus, un traitement supplémentaire visant à graver la base sous-jacente à la couche d'arrêt du substrat, les tronçons dans la couche d'arrêt dans le substrat et/ou les saillies servant de masque, les nanostructures étant matérialisées au moins par des tronçons, à l'aplomb des tronçons dans la couche d'arrêt, gravés dans la base, obtenus lors du traitement supplémentaire.

Une couche additionnelle peut être insérée entre la base et la couche d'arrêt du substrat, on peut alors effectuer, de plus, un traitement additionnel visant à graver la couche additionnelle, les tronçons et/ou les saillies dans la couche d'arrêt pouvant servir de masque, les nanostructures étant matérialisées au moins par des tronçons à l'aplomb des tronçons dans la couche d'arrêt, gravés dans la couche additionnelle, obtenus lors du traitement additionnel.

La gravure du traitement additionnel peut être arrêtée par la base du substrat ce qui permet également de maîtriser la hauteur des nanostructures.

La base du substrat peut être multicouche et comporter une couche d'arrêt sous-jacente à la couche additionnelle.

On peut prévoir une étape d'élimination des saillies, ce qui permet que les sommets des nanostructures soient inclus dans un même plan.

On peut également prévoir une étape d'élimination des tronçons gravés dans la couche d'arrêt du substrat pour ne conserver que des tronçons sous-jacents.

La couche additionnelle peut être réalisée en matériau semi-conducteur cristallin.

Les attaques et/ou le traitement complémentaire et/ou le traitement supplémentaire et/ou le traitement additionnel peuvent être choisis parmi la gravure sèche ou humide, chimique, ionique, électrochimique, photochimique, thermique, sous atmosphère oxydante ou réductrice.

On peut prévoir qu'au moins une étape d'attaque ou de traitement soit une gravure anisotrope de manière à facetter les nanostructures.

On peut prévoir qu'au moins une étape d'attaque ou de traitement ait une vitesse d'attaque différente selon le matériau mis en jeu. L'attaque peut par exemple avoir une vitesse très faible dans la couche d'arrêt par rapport à celle qui existe au niveau des saillies pour ajuster les dimensions latérales des saillies.

On peut prévoir qu'au moins une étape d'attaque ou de traitement soit une gravure anisotrope de manière à reporter le relief des saillies déjà créées.

On peut utiliser en tant que premier substrat intermédiaire et en tant de second substrat intermédiaire, des substrats semi-conducteur sur isolant ayant chacun un film semi-conducteur prélevé dans un même bloc de matériau semi-conducteur cristallin, les faces cristallines des substrats intermédiaires étant celles des films.

Le prélèvement peut se faire pour l'un des substrats semi-conducteur sur isolant :
- en formant une couche d'oxyde en surface du bloc,
- en créant une zone fragilisée au sein du bloc sous la couche d'oxyde par implantation ionique,
- en assemblant le bloc par sa couche d'oxyde à un substrat auxiliaire,
- en provoquant une fracture au niveau de la zone fragilisée, le matériau se trouvant entre la couche d'oxyde et la zone fragilisée formant le film du substrat, le reste du bloc formant un élément restant.

Pour l'autre substrat semi-conducteur sur isolant, le prélèvement peut se faire:
- en formant une couche d'oxyde en surface de l'élément restant,
- en créant une autre zone fragilisée au sein de l'élément restant sous la couche d'oxyde par implantation ionique,
- en assemblant l'élément restant par sa couche d'oxyde à un autre substrat auxiliaire,
- en provoquant une fracture au niveau de l'autre zone fragilisée, le matériau se trouvant entre la couche d'oxyde et l'autre zone fragilisée formant le film de l'autre substrat semi-conducteur sur isolant.

Pour améliorer la précision de la localisation du réseau de défauts cristallins et/ou de champs de contraintes, on peut graver des marques de repérage dans le bloc avant son assemblage au substrat auxiliaire, ces marques s'étendant au-delà de la zone fragilisée jusqu'à atteindre l'autre zone fragilisée, ces marques de repérage facilitant le décalage des réseaux cristallins.

Pour éviter une désorientation de flexion, on peut faire tourner l'une des faces de 180° par rapport à l'autre à l'aide des marques de repérage avant d'introduire le décalage des réseaux cristallins.

En variante, le premier semi-conducteur sur isolant peut être un substrat semi-conducteur sur isolant double, son substrat auxiliaire étant un substrat semi-conducteur sur isolant avec une couche isolante, insérée entre une couche et un film en matériau semi-conducteur, caractérisé en ce qu'il consiste à assembler le film du substrat auxiliaire à la couche d'oxyde.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels:
les figures 1A à 1E présentent différentes étapes d'un exemple du procédé selon l'invention ;
les figures 2A à 2E présentent des étapes complémentaires à effectuer à la suite des étapes précédentes pour obtenir des nanostructures dont les sommets sont inclus dans un même plan ;
les figures 3A à 3D présentent différentes étapes du procédé selon l'invention dans lequel les nanostructures ont une hauteur sensiblement constante ;
les figures 4A à 4L présentent différentes étapes du procédé selon l'invention dans lequel on travaille deux substrats semi-conducteur sur isolant ayant des films semi-conducteurs issus d'un même bloc de matériau semi-conducteur, le bloc étant illustré sur la figure 4L;
les figures 5A à 5H présentent différentes étapes du procédé selon l'invention dans lequel on travaille deux substrats semi-conducteurs sur isolant ayant des films semi-conducteurs issus d'un même bloc de matériau semi-conducteur, l'un de ces substrats étant un substrat semi-conducteur sur isolant double ;
les figures 6A à 6G présentent différentes étapes d'un autre exemple du procédé selon l'invention dans lequel un film possédant un réseau de défaits cristallins et/ou de champs de contraintes est rapporté sur un substrat intermédiaire recouvert d'une couche d'arrêt.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

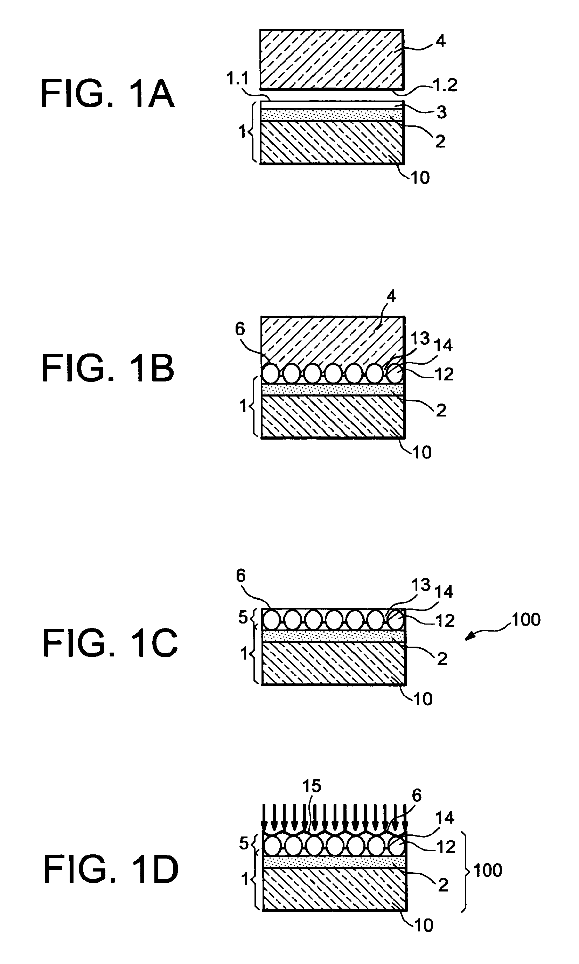

On va maintenant en se référant à aux figures 1A à 1E détailler un premier exemple d'un procédé de réalisation de nanostructures sur un substrat selon l'invention.

On part d'un premier substrat intermédiaire 1 comportant une face cristalline 1.1 formé par un film 3 en matériau semi-conducteur cristallin recouvrant une couche d'arrêt 2 et d'un second substrat intermédiaire 4 comportant une face 1.2 cristalline. Le premier substrat intermédiaire 1 peut être, dans cet exemple, un substrat semi-conducteur sur isolant avec une base 10 et le film 3, par exemple en silicium, et entre les deux, une couche en matériau isolant, par exemple en oxyde de silicium, la couche en matériau isolant servant de couche d'arrêt 2 à la gravure.

Le second substrat intermédiaire 4 peut être en silicium. Avantageusement, il pourra comporter une couche d'arrêt enterrée pour faciliter son amincissement ultérieur. Ce pourra être par exemple un substrat SOI (silicium sur isolant).

Plus généralement, la base 10 et le film 3 du premier substrat intermédiaire 1, le second substrat intermédiaire 4 peuvent être en silicium, en germanium, en arséniure de gallium GaAs, en carbure de silicium SiC, en phosphure d'indium InP. La couche d'arrêt 2 quand à elle peut être, par exemple, en oxyde de silicium, en nitrure de silicium, en silicium amorphe.

Il est possible que la base 10 et le film 3 du premier substrat intermédiaire 1, le second substrat intermédiaire 4 et la couche d'arrêt 2 soient multicouches.

On peut se référer à la figure 1A.

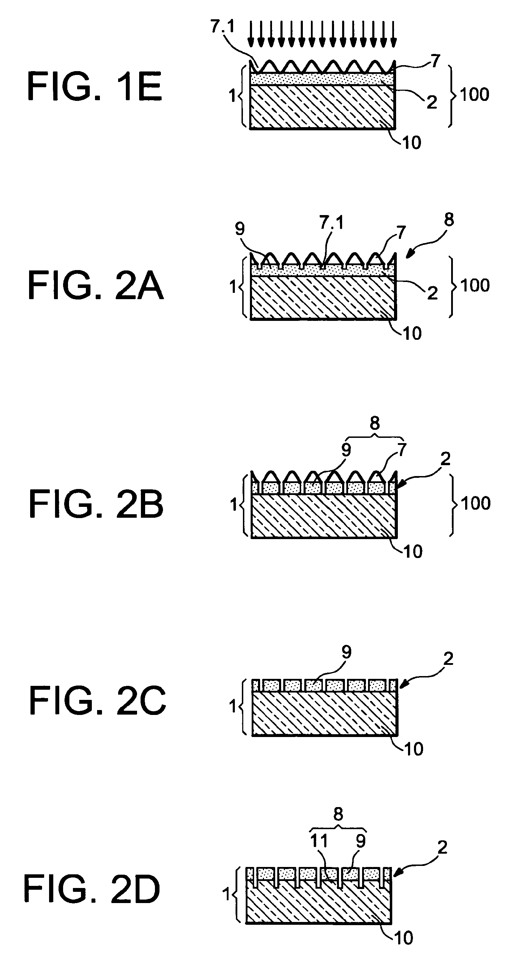

On va coller par adhésion moléculaire les deux faces cristallines 1.1 et 1.2 des deux substrats intermédiaires 1 et 4. Cette adhésion se fait de manière à ce que leurs réseaux cristallins soient décalés d'un angle prédéterminé appelé par la suite angle de décalage. Cet angle de décalage n'est pas visible sur les figures 1, mais on peut se référer aux demandes de brevets FR-A-2 815 121, FR-A-2 766 620 et même à la demande de brevet FR-A-2 819 099 qui exposent la manière de procéder et les conséquences de ce collage.

Le collage permet de raccorder les réseaux cristallins présents sur les deux faces 1.1 et 1.2 et provoque la formation d'un réseau de défauts cristallins et/ou de champs de contraintes 12 au sein d'une zone cristalline 13 au voisinage de l'interface 14 de collage. On s'aperçoit que des défauts cristallins, par exemple des dislocations apparaissent à l'interface 14 et elles entraînent des zones contraintes au voisinage de cette interface 14. On peut se référer à la figure 1B.

On va ensuite amincir le second substrat intermédiaire 4 à partir de son autre face, cet amincissement peut conduire ou non à une nanostructuration de surface révélant la présence du réseau de défauts cristallins et/ou de champs de contraintes 12. En fait, le but de cet amincissement est de former le film 5 qui limite l'épaisseur la zone cristalline 13 au sein de laquelle se trouve le réseau de défauts cristallins et/ou de champs de contraintes 12. Cette zone cristalline 13 a une épaisseur qui est la somme de l'épaisseur du film 3 du premier substrat intermédiaire 1 et de celle du film 5 issu du second substrat intermédiaire 4. Le substrat 100 obtenu à ce stade est illustré à la figure 1C. Dans ce cas, le réseau de défauts cristallins et/ou de champs de contraintes 12 n'est pas révélé en surface.

L'amincissement peut se faire par exemple par rectification, par abrasion mécanique et/ou même par attaque chimique.

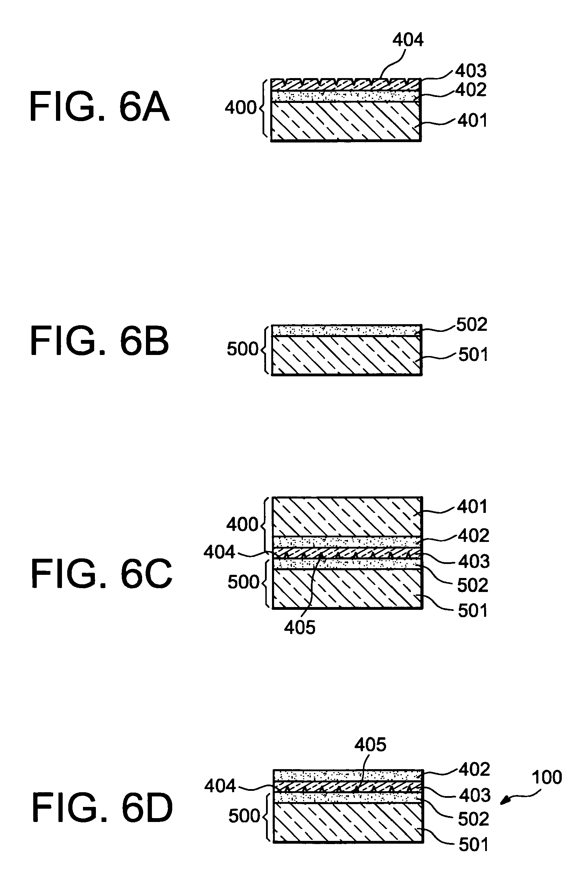

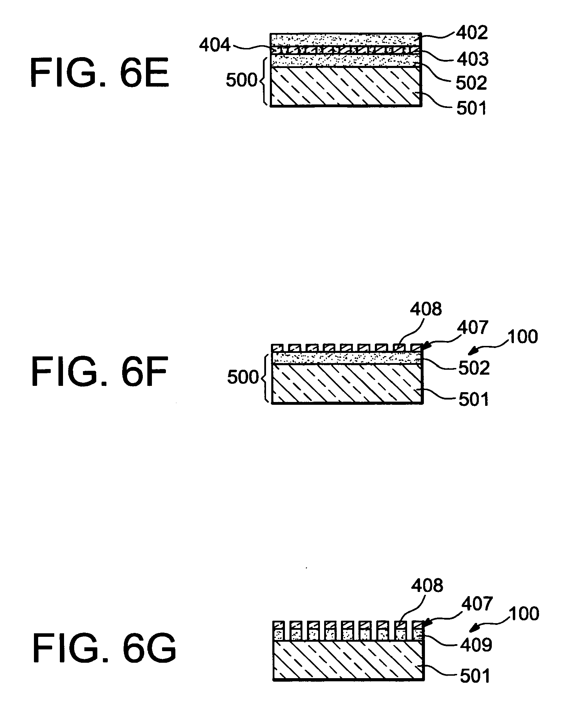

En variante, comme illustré sur les figures 6 décrites ultérieurement, il serait possible de disposer du substrat 100 en reportant sur un support 101 recouvert d'une couche 102 qui servira ultérieurement de couche d'arrêt à la gravure un film 103 incluant ce réseau de défauts cristallins et/ou de champs de contraintes. Ce film 103 peut être obtenu en suivant l'enseignement des demandes de brevet FR-A-2 766 620 ou FR-A-2 815 121.

L'étape suivante consiste à effectuer au moins une attaque préférentielle de la face libre du substrat 100 de manière à faire apparaître des reliefs 15. Par attaque préférentielle ou encore appelée sélective, on entend une gravure attaquant principalement les défauts cristallins et/ou les champs de contraintes 12, par rapport à la zone cristalline 13 située entre les défauts cristallins et/ou les champs de contraintes ou réciproquement attaquant principalement la zone cristalline 13 par rapport aux défauts cristallins et/ou champs de contraintes 12. Sur la figure 1D, on suppose que ce sont les défauts cristallins et/ou les champs de contraintes 12 qui sont gravés préférentiellement par rapport à la zone de cristalline 13. L'inverse aurait bien pu être possible. La surface libre du substrat 100 traitée porte maintenant un réseau de reliefs 6 dont le motif ou la topologie de surface dépend du réseau de défauts cristallins et/ou de champs de contraintes 12 comme on peut l'entrevoir à la figure 1D.

On poursuit la gravure jusqu'à faire apparaître localement la couche d'arrêt 2. Cette gravure n'est pas forcément préférentielle vis à vis des défauts cristallins et/ou des champs de contraintes 12. Si elle est préférentielle, elle accentue les reliefs 6. La couche d'arrêt 2 peut ne pas être attaquée ou n'être que partiellement attaquée, à cette étape, d'où son nom de couche d'arrêt, elle est alors seulement mise à nu localement. On obtient donc au dessus de la couche d'arrêt 2, des saillies 7 séparées les unes des autres par des creux 7.1 ayant un fond situé au niveau de la couche d'arrêt 2. Les saillies 7 localisent les nanostructures. Elles conduisent aux nanostructures, en d'autres termes elles matérialisent ou contribuent à matérialiser les nanostructures. Les saillies 7 sont en matériau cristallin.

Ces saillies 7 sont agencées en réseau, leur répartition est ordonnée à la surface de la couche d'arrêt 2. Les saillies 7 suivent le motif du réseau de défauts cristallins et/ou du champ de contraintes ou bien son complémentaire, cela dépend si l'attaque préférentielle concernait le réseau de défauts cristallins et/ou de champs de contraintes 12 ou la zone cristalline voisine 13. La section des nanostructures qui vont être obtenues, dépend du pas du réseau de défauts cristallins et/ou de champs de contraintes 12 et de la vitesse d'attaque latérale des techniques de gravure utilisées.

Dans l'exemple des figures 1, les saillies 7 matérialisent les nanostructures 7 comme illustré à la figure 1E.

L'attaque qu'elle soit préférentielle ou non préférentielle, peut être une attaque sèche ou humide chimique, ionique, électrochimique, photochimique, thermique, sous atmosphère réductrice ou oxydante. Par attaque thermique, on englobe une oxydation thermique. Dans cette attaque, le matériau à attaquer est consommé en se transformant en oxyde. Plusieurs techniques d'attaques successives ou simultanées choisies parmi celles évoquées plus haut peuvent être employées entre le stade représenté à la figure 1C et celui représenté à la figure 1E. Une ou plusieurs de ces attaques peuvent être non préférentielles, cela peut être le cas pour passer du stade de la figure 1D à celui de la figure 1E. Une ou plusieurs attaques peuvent être des attaques anisotropes, dans le cas où on cherche notamment à amincir de façon anisotrope l'épaisseur des films 5 et 3. Une ou plusieurs de ces attaques peuvent être des attaques anisotropes, dans le cas où on cherche notamment à graver certains plans cristallins et pas d'autres. Cela conduit à réaliser des nanostructures 7 à une ou plusieurs facettes. On suppose que sur la figure 1E, les nanostructures 7 sont facettées. Avantageusement, certaines de ces attaques peuvent conduire à des vitesses de gravure différentes suivant la nature des couches rencontrées. Plus on s'approche de la couche d'arrêt 2, plus on aura intérêt à employer une méthode possédant une vitesse de gravure beaucoup plus faible dans la couche d'arrêt 2 que dans la couche à graver. L'attaque peut par exemple avoir une vitesse très faible dans la couche d'arrêt par rapport à celle qui existe au niveau des saillies pour ajuster les dimensions latérales des saillies. On pourra ainsi ajuster la largeur des saillies 7, en choisissant une attaque n'affectant que peu la couche d'arrêt 2 et privilégiant la gravure des saillies 7, notamment la gravure latérale.

Au terme des différentes opérations d'attaque qui viennent d'être menées, il est possible que les saillies 7 ne soient pas directement les nanostructures que l'on cherche à obtenir, parce que leur hauteur n'est pas suffisante et/ou parce qu'elles n'ont pas toutes la même hauteur et/ou parce que les sommets de toutes les saillies ne sont pas inclus dans un plan. On va voir différentes manières de les retoucher, de les allonger ou de les transformer. Dans ce cas, les saillies 7 contribuent seulement à matérialiser les nanostructures.

Il est possible d'effectuer un traitement complémentaire visant à graver la couche d'arrêt 2 en se servant des saillies 7 comme d'un masque. Ainsi la couche d'arrêt 2 subit préférentiellement la gravure et les saillies 7 ne sont pas ou peu affectées. On pourra au besoin déposer au niveau des saillies 7 un matériau apte à renforcer la résistance des saillies vis à vis du traitement complémentaire comme on le décrira ultérieurement. La gravure peut ne pas traverser totalement la couche d'arrêt 2 comme illustré sur la figure 2A. Dans cette configuration les nanostructures, maintenant référencées 8, se prolongeant par des tronçons 9 dans la couche d'arrêt 2, ont une hauteur accrue par rapport à celle qu'elles avaient à la figure 1E.

En variante, il est possible de poursuivre le traitement complémentaire de manière à traverser totalement l'épaisseur de la couche d'arrêt 2. La base 10 du premier substrat intermédiaire 1 peut alors avoir un rôle de couche d'arrêt pour le traitement complémentaire. Cette variante est illustrée à la figure 2B.

Dans ces deux cas, les nanostructures 8 sont colonnaires et comportent chacune alors, en plus d'une saillie 7 provenant des films 5 et 3, le tronçon 9, à son aplomb, dans le matériau de la couche d'arrêt 2.

Le traitement complémentaire peut être choisi parmi une ou plusieurs des attaques sèches ou humides suivantes: ioniques, chimiques, électrochimiques, photochimiques, sous atmosphère oxydante ou réductrice. Si plusieurs attaques sont employées, elles peuvent être employées simultanément ou successivement. Il faut noter que le traitement complémentaire attaque préférentiellement la couche d'arrêt 2 plutôt que les saillies 7, ou la base 10 du premier substrat intermédiaire 1, si cette dernière a un rôle de couche d'arrêt.

Il est possible d'écrêter les nanostructures 8 obtenues en éliminant totalement ou partiellement les saillies 7 comme illustré sur la figure 2C. Cette élimination peut se faire par attaque sèche ou humide ionique, chimique, électrochimique, photochimique, sous atmosphère oxydante ou réductrice. La méthode employée ne doit pas attaquer le matériau de la couche d'arrêt 2. Par exemple si les saillies sont en silicium et la couche d'arrêt est en oxyde de silicium ou en nitrure de silicium, l'élimination des saillies pourra se faire avec du TMAH (tétraméthyle amonium hydroxyde) ou du KOH (hydroxyde de potassium). Cette élimination conduit à transformer les nanostructures 8 de manière à ce que leur sommet soit aplani. Si l'attaque complémentaire vise à s'arrêter sur la base 10 et que l'attaque d'écrêtage est sélective vis à vis de la base 10, la hauteur des nanostructures 8 est égale à l'épaisseur de la couche d'arrêt 2.

Pour augmenter encore la hauteur des nanostructures et/ou pour changer de matériau et/ou pour ajuster leur hauteur et/ou pour que leurs sommets soit tous dans un même plan, il est possible d'entreprendre un traitement supplémentaire qui affecte la base 10 et qui vise à la graver. Les saillies 7 peuvent être présentes et servir de masque pour ce nouveau traitement supplémentaire ou avoir déjà été éliminées comme illustré à la figure 2C. Dans cette configuration, on se sert de la couche d'arrêt 2 comme d'un masque. Ce cas est illustré à la figure 2D.

Les nanostructures 8 obtenues comportent alors à ce stade, depuis leur embase, un second tronçon 11, situé dans la base 10 du premier substrat intermédiaire 1, à l'aplomb des saillies, prolongé par le premier tronçon 9 situé dans la couche d'arrêt 2 et éventuellement par les saillies 7 si elles n'ont pas été ôtées.

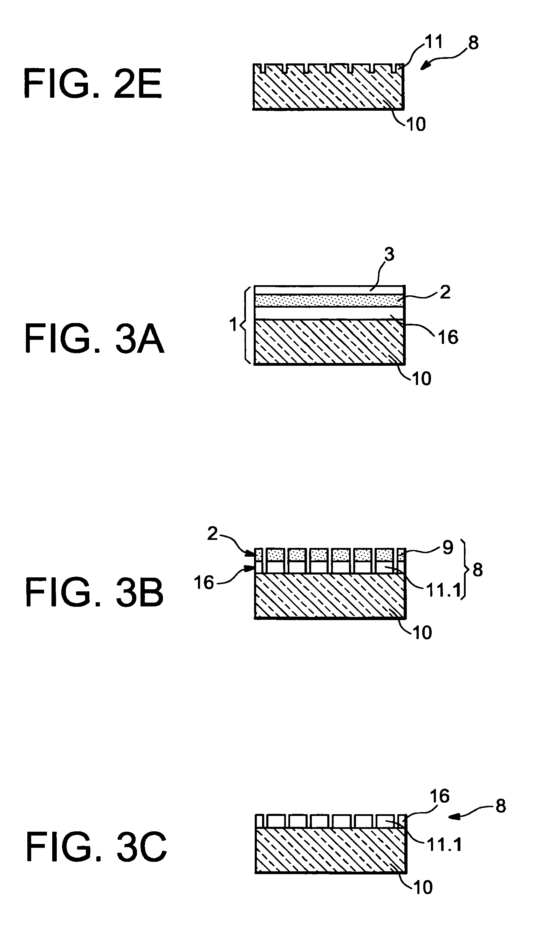

A ce stade, il est possible d'ôter les premiers tronçons 9, issus de la couche d'arrêt 2, par un traitement d'élimination approprié pour ne conserver que les seconds tronçons 11. Dans cet exemple illustré à la figure 2E, l'avantage de ne conserver que les seconds tronçons 11 est qu'il sont réalisés dans un matériau cristallin et que de plus toutes les nanostructures 8 ont alors leur sommet situé dans un même plan. En effet le sommet de ces nanostructures n'a pas été exposé directement à une attaque du matériau qui les constitue puisque les sommets de ces seconds tronçons 11 ont été protégés jusqu'à présent par la couche d'arrêt 2. Bien sûr si les saillies 7 n'avaient pas été ôtées auparavant, elles sont ôtées avec les premiers tronçons 9.

Pour donner aux nanostructures une même hauteur, il est possible d'utiliser un premier substrat intermédiaire 1 qui comporte une couche additionnelle 16 entre la base 10 et la couche d'arrêt 2 comme illustré sur la figure 3A. Cette couche additionnelle 16 peut être en germanium ou en silicium cristallin par exemple. Avec ce premier substrat intermédiaire 1, on peut procéder de la même manière qu'illustré aux figures 1 et 2, en effectuant un traitement additionnel visant à graver la couche additionnelle 16 au lieu de graver la base 10. Le traitement additionnel utilise la couche d'arrêt 2 comme masque et la base 10 comme couche dite d'arrêt. On peut se référer à la figure 3B. On suppose dans cet exemple que les saillies ont été ôtées avant de graver la couche additionnelle 16, c'est pourquoi elles ne sont pas visibles. Il aurait été bien sûr possible de les conserver. A ce stade les nanostructures 8 sont formées chacune d'un premier tronçon 9 formé dans la couche d'arrêt 2 et d'un second tronçon 11.1 formé dans la couche additionnelle 16. Puisque la gravure s'arrête sur la base 10, la hauteur de toute les nanostructures 8 est sensiblement constante une fois les saillies et les premiers tronçons 9 qui sont des fragments de la couche d'arrêt 2, ôtés. Cette hauteur correspondant à l'épaisseur de la couche additionnelle 16. Les nanostructures 8 sont alors réalisées, en entier, dans le matériau de la couche additionnelle 16. Leurs sommets sont sensiblement inclus dans un même plan. Cette variante est illustrée à la figure 3C. En procédant de la sorte, on maîtrise parfaitement la hauteur des nanostructures 8.

Si la couche d'arrêt 2 est en oxyde de silicium et que la couche additionnelle 16 en silicium, l'élimination de la couche d'arrêt 2 pourra se faire à l'aide d'acide fluorhydrique HF qui n'attaque pas le silicium mais dissout son oxyde.

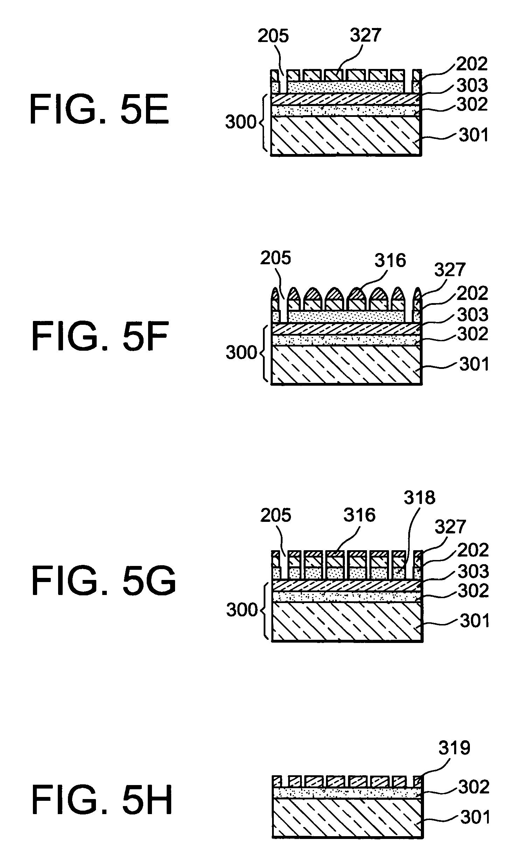

On peut envisager que la base 10 soit multicouche et comporte une couche d'arrêt sous-jacente à la couche additionnelle 16. On peut se référer par exemple à la figure 5H sur laquelle la base est formée de l'empilement de la couche 301 en silicium et de la couche 302 en nitrure de silicium, la couche 302 en nitrure de silicium formant la couche d'arrêt sous-jacente à la couche 303 qui elle est en silicium.

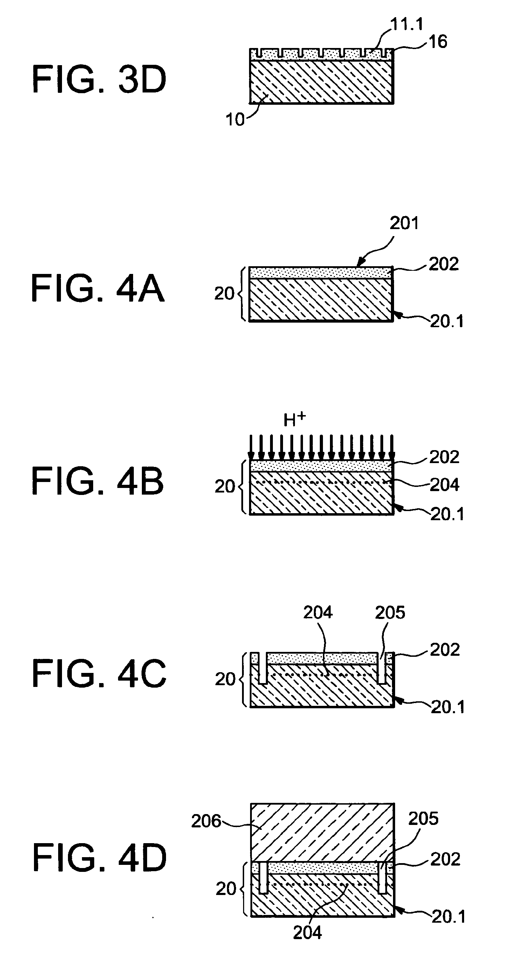

Il est bien sûr possible d'arrêter la gravure avant d'atteindre la base 10 de la même manière qu'expliqué à la figure 2A. Dans ce cas, les nanostructures 8 correspondent aux seconds tronçons 11.1 qui sont gravées dans le matériau de la couche additionnelle 16 comme illustré à la figure 3D mais cette configuration n'est pas forcément optimale car les nanostructures n'auront pas forcément la même hauteur. Dans cette configuration, on conserve l'avantage qui est que le sommet de toutes les nanostructures est inclus dans un même plan.

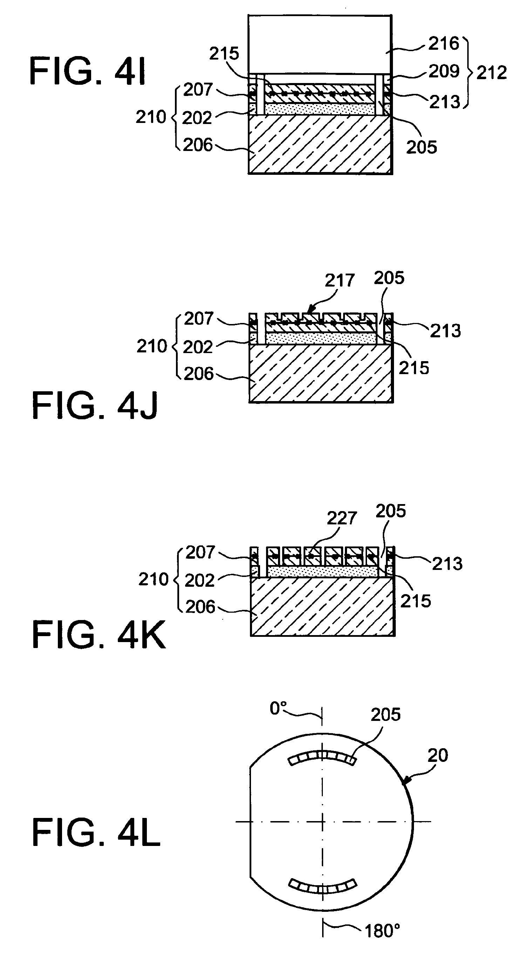

On va maintenant décrire en détail un autre exemple de procédé d'élaboration de nanostructures selon l'invention en se référant aux figures 4A à 4K. Dans cet exemple, on va réaliser deux substrats semi-conducteur sur isolant intermédiaires en tant que premier et second substrat intermédiaire. On rappelle qu'un substrat de type semi-conducteur sur isolant, connu sous la dénomination SOI s'il s'agit de silicium sur isolant, comporte deux couches de matériau semi-conducteur situées de part et d'autre d'une couche d'isolant. L'une des couches de semi-conducteur est moins épaisse que l'autre. Par la suite, la couche la moins épaisse est appelée film. Les films des deux substrats SOI vont provenir d'un même monocristal ou bloc de matériau semi-conducteur cristallin. On va assembler les deux substrats semi-conducteur sur isolant intermédiaires avec un angle de décalage bien précis en suivant l'enseignement de la demande de brevet FR-A-2 819 099. Cette méthode permet de n'apporter qu'une désorientation angulaire de torsion et pas de désorientation angulaire de flexion.

On part d'un bloc 20 de matériau semi-conducteur cristallin, par exemple du silicium présentant une face libre 201 orientée dans la direction <001>. Ce bloc peut être une tranche de silicium de 100 millimètres de diamètre par exemple possédant un méplat 20.1 sur un de ses bords. Dans l'exemple, ce bloc 20 est massif mais en variante il pourrait être multicouche et présenter en surface une couche de matériau semi-conducteur dans laquelle on viendrait de prélever les deux films nécessaires pour obtenir le réseau de défauts cristallins et/ou de champs de contraintes. On va traiter ce bloc 20 de manière à pouvoir en prélever deux éléments, ayant des surfaces cristallines qui seront collées l'une à l'autre par la suite. On peut commencer par former une couche d'oxyde 202 en oxydant thermiquement la face libre 201 du bloc 20. Cette couche d'oxyde 202 peut avoir une épaisseur d'environ 400 nanomètres. Elle va former la couche isolante du futur substrat SOI. Cette étape est illustrée sur la figure 4A.

On va ensuite fragiliser une zone du bloc 20 au moyen d'ions implantés, par exemple des ions d'hydrogène ou de tout autre espèce gazeuse apte à former une zone fragile enterrée 204 au niveau de laquelle une fracture pourra s'opérer. La zone de fragilisation 204 illustrée sur la figure 4B va prendre la forme d'un plan situé dans le silicium du bloc 20 sous la couche d'oxyde 202. L'implantation se fait depuis la surface libre de la couche d'oxyde 202. L'énergie d'implantation peut être d'environ 76 keV et la dose d'ions hydrogène valoir environ 6.10¹⁶ atomes/cm².

On réalise ensuite une ou plusieurs marques de repérage 205, par exemple par photolithographie et gravure ionique ou autre dans la couche d'oxyde 202 et dans le semi-conducteur sous-jacent du bloc 20, ces marques de repérage 205 empiètant dans le bloc 20 au-delà de la zone de fragilisation 204 par rapport à la couche d'oxyde 202. Leur profondeur peut être d'environ 5 micromètres. D'autres méthodes de gravure de ces marques de repérage pourraient être utilisées, par exemple, chimique ou laser. Les marques de repérage 205 pourraient en variante traverser totalement le bloc 20. On peut se référer à la figure 4C qui illustre ces marques de repérage 205 ainsi qu'à la figure 4K qui montre en vue de dessus le bloc 20 avec son méplat 20.1 et ses marques de repérage 205. Ces marques de repérage peuvent être configurées comme expliqué dans la demande de brevet FR-A-2 819 099 et prendre la forme d'échelles en arc de cercle, graduées tous les 0,01°, à 10 millimètres du bord du bloc 20. On prévoit par exemple deux marques de repérage 205 diamétralement opposées sur le bloc 20, elles s'étendent de plus ou moins 10° de part et d'autre des positions 0° et 180°.

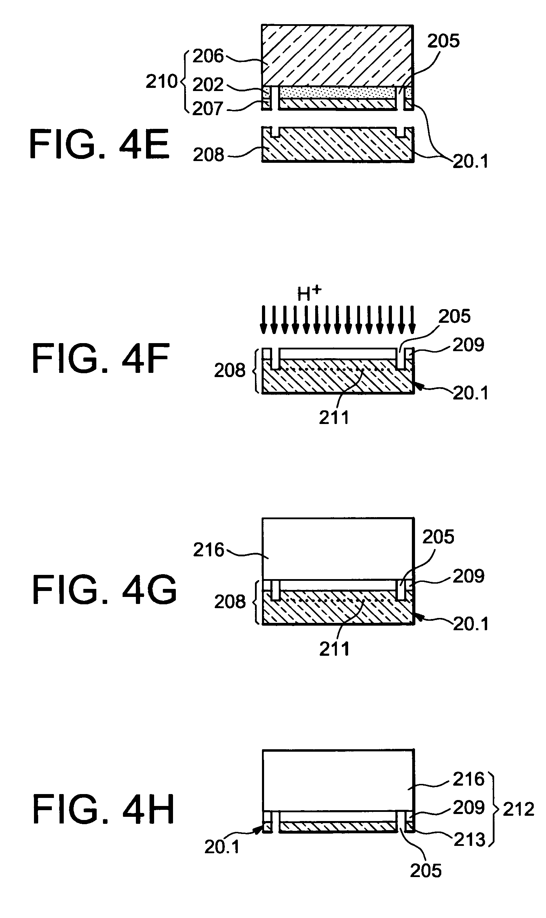

On assemble ensuite, à la figure 4D, la structure de la figure 4C sur un premier substrat auxiliaire 206 en matériau semi-conducteur, par exemple en silicium. Cet assemblage se fait par la face portant la couche d'oxyde 202. La méthode d'assemblage peut être un collage moléculaire hydrophile. On provoque ensuite à la figure 4E une fracture le long du plan de la zone fragilisée 204, par exemple, par un traitement thermique et/ou mécanique. Le traitement thermique peut avoir lieu pendant une heure à 500°C par exemple. Ce traitement thermique a comme avantage de renforcer l'adhésion moléculaire.

On est en présence de deux éléments 210, 208 comme illustré sur la figure 4E. L'un des éléments 210 est un substrat semi-conducteur sur isolant, il est formé du premier substrat auxiliaire 206, de la couche d'oxyde 202 et d'un film de silicium 207 prélevé dans le bloc de base 20 grâce à la fracture. Il est appelé par la suite premier substrat semi-conducteur sur isolant intermédiaire 210, il est gardé en l'état. L'autre élément 208 est massif dans notre exemple, il correspond à ce qui reste du bloc 20, il est appelé élément restant. Les deux éléments 208, 210 sont munis des marques de repérage 205 et comportent une partie cristalline 207, 208 qui provient du bloc 20. L'élément restant 208 va être travaillé pour conduire à un second substrat semi-conducteur sur isolant intermédiaire.

L'élément restant 208 est soumis à un traitement de polissage pour l'aplanir sans bien sûr faire disparaître ses marques de repérage 205. On forme une couche d'oxyde 209 sur la face de l'élément 208 du côté des marques de repérage 205. On peut lui donner une épaisseur d'environ 100 nanomètres.

On va ensuite réaliser une zone de fragilisation 211 au sein du matériau semi-conducteur de l'élément restant 208 par implantation ionique, par exemple avec des ions hydrogène, comme expliqué à la figure 4B. L'énergie d'implantation peut être d'environ 76 keV et la dose d'ions hydrogène valoir environ 6.10¹⁶ atomes/cm². La structure de la figure 4F illustre la zone de fragilisation 211 et la couche d'oxyde 209.

On assemble ensuite, à la figure 4G, la structure de la figure 4F sur un second substrat auxiliaire 216 en matériau semi-conducteur, par exemple en silicium. Cet assemblage se fait par la face portant la couche d'oxyde 209. La méthode d'assemblage peut être un collage moléculaire hydrophile. On provoque ensuite à la figure 4H une fracture le long du plan de la zone fragilisée 211, par exemple, par un traitement thermique par exemple à 500°C pendant une heure. Ce traitement thermique a comme avantage de renforcer l'adhésion moléculaire.

On est en présence de deux éléments dont l'un seulement 212 est illustré sur la figure 4H. Il s'agit du second substrat semi-conducteur sur isolant intermédiaire 212, il est formé du second substrat auxiliaire 216, de la couche d'oxyde 209 et d'un film 213 de silicium prélevé dans l'élément restant 208 grâce à la fracture. Cet élément restant 208 a également été prélevé dans le bloc 20. En conclusion, on est en bien présence de deux substrats semi-conducteur sur isolant intermédiaires 210, 212 ayant chacun un film 207, 213 prélevé dans le bloc 20. De plus ces deux films 213, 207 sont dotés des marques de repérage 205.

On va ensuite assembler les deux substrats semi-conducteurs sur isolant intermédiaires 210, 212 par leurs films 213, 207 avec un collage moléculaire de manière à générer le réseau de défauts cristallins et/ou de champs de contraintes. Il est préférable de préparer les deux faces libres cristallines des deux films 207, 213 pour pouvoir réaliser un collage moléculaire hydrophobe. Cette préparation peut comprendre tout ou partie des traitements suivants :
rodage, oxydation thermique, désoxydation, polissage mécano-chimique, nettoyage chimique par exemple à l'aide de solutions aqueuses à base de H₂SO₄ et de H₂O₂ ou à base de NH₃ et de H₂O₂, traitement à l'aide d'ozone ou de plasma (par exemple plasma d'oxygène), traitement pour rendre la surface hydrophobe avec de l'acide fluorhydrique par exemple. La préparation peut aussi inclure un amincissement d'au moins un des deux films 207, 213 à environ 100 nanomètres.

Avant le collage, on aligne les deux méplats 20.1 dont sont dotés les deux substrats semi-conducteur sur isolant intermédiaires 210, 212. On entraîne l'un des deux substrats semi-conducteur sur isolant intermédiaires 210, 212, par exemple le second substrat intermédiaire 212, en rotation sur 180° et on aligne ses marques de repérage 205 avec celles du premier substrat semi-conducteur sur isolant intermédiaire 210, ainsi ses marques de repérage placées à 0° et 180° sont alignées avec les marques de repérage placées à 180° et 0° respectivement du premier substrat semi-conducteur sur isolant intermédiaire 210. Cette manipulation a pour but d'éliminer une éventuelle désorientation de flexion qui peut exister entre les deux surfaces à assembler. Ensuite, grâce aux marques de repérage 205 avec des graduations tous les 0,01°, on peut introduire un angle de décalage en rotation de 0,88° bien précis entre les deux réseaux cristallins des films 207 et 213.

On effectue un collage moléculaire par exemple hydrophobe que l'on peut consolider grâce à un recuit thermique à une température supérieure à 900°C pendant plus de 10 minutes. La structure obtenue est illustrée à la figure 4I. Le réseau de défauts cristallins et/ou de champs de contraintes a été généré au voisinage de l'interface 215 comme décrit plus haut.

On va ensuite éliminer la couche épaisse et la couche isolante de l'un des substrats semi-conducteur sur isolant intermédiaires 210, 212. Dans l'exemple, il s'agit du second substrat semi-conducteur sur isolant intermédiaire 212 que l'on amincit, mais on pourrait envisager que ce soit l'autre. On ne conserve que le film de 213.

On va ensuite faire apparaître en surface des reliefs ordonnés 217 à l'échelle nanométrique en attaquant préférentiellement les défauts cristallins et/ou les champs de contraintes en utilisant par exemple une solution aqueuse de HF et de CrO₃ ou de HF et de HNO₃. Les reliefs 217 sont visibles à la figure 4J.

On poursuit une opération d'attaque jusqu'à atteindre la couche isolante 202 du premier substrat semi-conducteur sur isolant intermédiaire 210, cette dernière couche a un rôle de couche d'arrêt. Cette attaque plus profonde peut se faire avec les solutions évoquées plus haut, ou utiliser avec d'autres solutions aqueuses par exemple à base de NH₃ et de H₂O₂ ou à base de TMAH ou de KOH. Au lieu de continuer avec une attaque chimique humide, il est possible de passer à une attaque sèche par exemple de type ionique (connue sous la dénomination de RIE (reactive ionic etching). En se rapprochant de la couche d'arrêt 202, il est préférable d'utiliser un type de gravure qui présente un différentiel de vitesse d'attaque entre le silicium et son oxyde. Ainsi une gravure chimique avec du TMAH ou certaine gravure RIE présentent une vitesse 1000 fois plus élevée dans le silicium que dans l'oxyde. On arrête la gravure dès que des fragments de la couche isolante 202 sont mis à nu. On obtient donc des saillies 227 en matériau cristallin formées chacune d'un tronçon du film 207 du premier substrat semi-conducteur sur isolant intermédiaire 210 et d'un tronçon du film 213 du second substrat semi-conducteur sur isolant 2 intermédiaire 12, les deux tronçons étant empilés. Ces saillies 217 sont des nanocristaux de silicium qui sont supportés par la couche d'oxyde 202 du premier substrat semi-conducteur sur isolant intermédiaire 210. On peut se référer à la figure 4K.

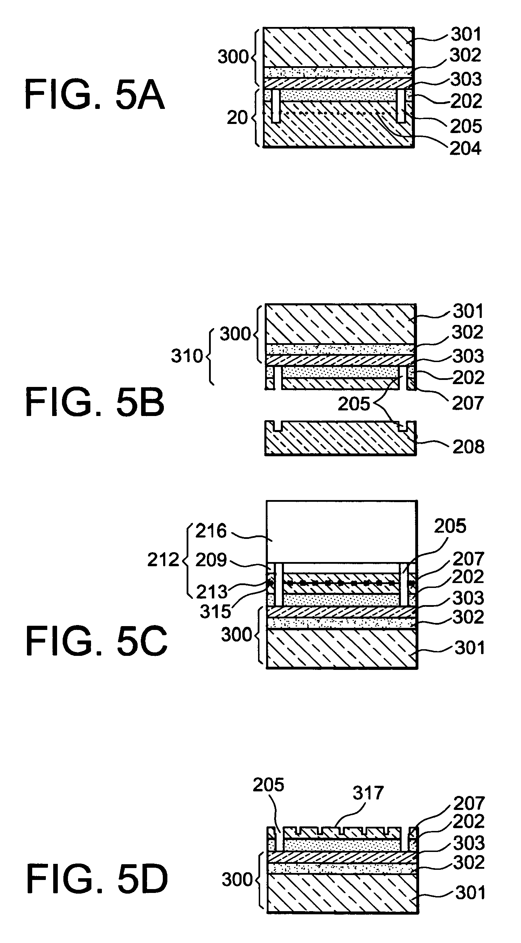

On va maintenant décrire encore un autre exemple d'un procédé selon l'invention en se référant aux figures 5A à 5H. Dans cet exemple on va employer deux substrats semi-conducteur sur isolant intermédiaires dont l'un d'entre eux est un double substrat semi-conducteur sur isolant, c'est à dire qu'il comporte un empilement alterné avec trois couches de matériau semi-conducteur et deux couches d'isolant et dont l'autre peut être simple. L'une des couches externes du matériau semi-conducteur du substrat semi-conducteur sur isolant double est un film cristallin. De la même manière que précédemment, ce film cristallin va être assemblé par collage moléculaire au film cristallin de l'autre substrat semi-conducteur sur isolant de manière à générer le réseau de défauts cristallins et/ou de champs de contraintes.

On part d'une structure telle qu'obtenue à la figure 4C avec un bloc 20 de matériau semi-conducteur cristallin par exemple du silicium dont une face comporte une couche d'oxyde 202, avec une zone fragilisée 204 par implantation ionique et des marques de repérage 205.

On colle par collage moléculaire hydrophile la structure de la figure 4C par sa couche d'oxyde 202 sur un substrat semi-conducteur sur isolant auxiliaire 300 formé d'un empilement avec une couche de silicium 301, une couche de nitrure de silicium 302 et un film 303 de silicium cristallin. Le film 303 de silicium cristallin a une épaisseur d'environ 5 nanomètres et la couche de nitrure de silicium 302 une épaisseur d'environ 400 nanomètres. L'assemblage se fait entre la couche d'oxyde de silicium 202 et le film de silicium 303. On peut se référer à la figure 5A.

On procède à une opération de recuit afin de consolider l'interface de collage 315 et de provoquer en même temps la fracture au niveau de la zone fragilisée 204. On obtient deux éléments d'une part, le substrat semi-conducteur sur isolant double 310 comme illustré à la figure 5B formé du substrat semi-conducteur sur isolant auxiliaire 300, de la couche d'oxyde 202 et d'un film de silicium 207 provenant du bloc 20 et d'autre part l'élément 208 qui correspond à ce qui reste du bloc 20. Les marques de repérage 205 sont présentes dans l'élément 208, dans le film 207 et dans la couche d'oxyde 202. On peut se référer à la figure 5B.

On va traiter l'élément 208 comme expliqué aux figures 4F à 4H pour obtenir le substrat semi-conducteur sur isolant intermédiaire 212 qui est simple. On ne réécrit pas et ne représente pas à nouveau cet enchaînement d'étapes pour ne pas alourdir la description.

On va maintenant assembler les deux substrats semi-conducteur sur isolant intermédiaires 310, 212 par leurs films 207, 213 en réalisant un collage moléculaire de manière à générer le réseau de défauts cristallins et/ou de champs de contraintes. Cette étape est illustrée à la figure 5C. On procède au même type de préparation des films 213, 207 que décrit précédemment. On effectue également les mêmes manipulations avant le collage pour éliminer d'éventuelles désorientations de flexion.

On va procéder à l'élimination de la couche épaisse 216 et à la couche isolante 209 du substrat semi-conducteur sur isolant simple 212 comme expliqué plus haut pour le second substrat semi-conducteur sur isolant intermédiaire 212 de manière à ne conserver que son film 213.

On attaque ensuite préférentiellement le réseau de défauts cristallins et/ou de champs de contraintes qui s'est formé à l'interface 315. Cette attaque peut se faire comme décrit à la figure 4J, c'est à dire avec une solution aqueuse de HF et de CrO₃ ou de HF et de HNO₃. On fait apparaître des reliefs 317 qui sont illustrés à la figure 5D. On poursuit une étape d'attaque pour atteindre la couche isolante 202 en oxyde de silicium qui sert à ce stade de couche d'arrêt. On forme ainsi les saillies 327 qui conduisent aux nanostructures. Cette attaque, illustrée à la figure 5E, jusqu'à la couche d'arrêt 202, peut employer les mêmes solutions que l'on a employé pour faire apparaître les reliefs 317 ou d'autres méthodes telles que celles citées lors de la description de la figure 4K: attaque chimique avec une solution aqueuse à base de NH₃ et de H₂O₂ ou à base de TMAH ou de KOH, ou attaque ionique. On obtient ainsi des saillies 327 de même nature que celles illustrées à la figure 4K. Ces saillies 327, en matériau cristallin, peuvent matérialiser les nanostructures si on s'arrête là, mais dans cet exemple particulier, elles contribuent seulement à les matérialiser car on va continuer à graver en profondeur le substrat SOI double 310 pour atteindre la couche isolante 302 en nitrure de silicium. Les saillies 327 vont servir de masque de gravure pour graver, dans un premier temps, des tronçons, à leur aplomb, dans la couche isolante 202 du substrat semi-conducteur sur isolant double 310. Pour renforcer la dureté du masque, il est possible de déposer un film métallique 316, par exemple de nickel, sur les saillies 327. Ce dépôt peut se faire par pulvérisation. Le film 316 de nickel se dépose également sur la couche isolante 202 dont certains fragments sont à nu. En portant la structure obtenue après pulvérisation du nickel à une température de quelques centaines de degrés, le film 316 de nickel démouille et se localise sous forme de gouttes au sommet des saillies 327. On peut se référer à la figure 5F. Le nickel possède en effet une plus grande affinité avec le silicium qu'avec son oxyde. Par gravure ionique réactive, il est possible de graver la couche isolante 202 en oxyde. Des premiers tronçons en oxyde de silicium sont obtenus dans le prolongement des saillies 327, ils sont référencés 318 sur la figure 5G. On peut ensuite enchaîner avec une gravure de la couche 303 de matériau semi-conducteur sous-jacente, en changeant par exemple la nature du gaz employé.

La gravure de la couche de silicium 303 permet d'obtenir sous les premiers tronçons 318, des seconds tronçons 319 de silicium, la couche isolante 202 qui vient d'être gravée servant de masque. Les seconds tronçons 319 sont à l'aplomb des premiers tronçons 318. La couche sous-jacente 302 de nitrure de silicium sert de couche d'arrêt à cette étape de gravure. Les seconds tronçons 319 en silicium obtenus matérialisent les nanostructures. On élimine par la suite le film 316 de nickel, les saillies 327, les premiers tronçons 318 d'oxyde provenant de la couche 202, par attaque chimique ou ionique réactive. On peut par exemple employer de l'acide fluorhydrique HF qui va dissoudre seulement les premiers tronçons 318 d'oxyde provenant de la couche 202 et provoquer l'enlèvement du nickel et des saillies 327 sans attaquer ni les seconds tronçons 319 de silicium ni la couche 302 de nitrure de silicium. Les sommets de toutes les nanostructures 319 sont inclus dans un même plan. La hauteur des nanostructures 319 est la même, elle correspond à l'épaisseur de la couche se silicium 302. On peut se référer à la figure 5H.

On va maintenant décrire en se référant aux figures 6A à 6G, un autre exemple de procédé d'élaboration de nanostructures selon l'invention. On part d'un premier substrat intermédiaire 400 et d'un second substrat intermédiaire 500. Le premier substrat intermédiaire 400 illustré sur la figure 6A est formé d'un empilement avec une base de silicium 401, une couche d'oxyde de silicium 402 et un film de silicium 403 présentant en surface un réseau de saillies 404. Ce premier substrat intermédiaire 400 peut être obtenu en s'inspirant de l'enseignement de la demande de brevet FR-A-2 815 121. Le second substrat intermédiaire 500, illustré sur la figure 6B, est formé d'une base 501 recouverte d'une couche 502 d'oxyde de silicium qui va servir de couche d'arrêt du substrat 100 que l'on cherche à obtenir. Comme illustré sur la figure 6C, on va assembler le premier substrat intermédiaire 400 au second substrat intermédiaire 500 en mettant en contact le film de silicium 403 doté du réseau de saillies 404 et la couche d'arrêt 502. L'assemblage peut se faire par collage moléculaire hydrophile par exemple. Les zones en creux situées entre les saillies du réseau vont générer des cavités enterrées 405 au niveau de l'interface de collage avec la couche d'arrêt 502.

On va ensuite éliminer, à la figure 6D, la base 401 du premier substrat intermédiaire 400, par exemple par un amincissement mécanique. On obtient le substrat 100 que l'on va doter de nanostructures.

On va pouvoir commencer les attaques. Dans cet exemple, on commence par un traitement d'oxydation thermique du silicium du film 403 portant le réseau de saillies 404. L'oxyde se forme aux interfaces avec les couches d'oxyde 402 et avec la couche d'arrêt 502. Au niveau de l'interface avec la couche d'oxyde 502 l'oxyde se forme préférentiellement au niveau des cavités enterrées 405 du fait de la contrainte induite dans ces cavités 405 par le traitement thermique. L'oxydation thermique peut faire disparaître tout ou partie de ces cavités enterrées 405. L'oxydation thermique conduit à l'apparition dans le film 403 de zones d'oxyde traversantes comme illustré à la figure 6E.

On poursuit par une gravure préférentielle de l'oxyde de silicium vis à vis du silicium et on fait apparaître des saillies 407 qui peuvent former les nanostructures recherchées comme illustré sur la figure 6F. Cette gravure peut se poursuivre et descendre dans la couche d'arrêt 502 à l'aplomb des endroits où se trouvaient à l'origine les saillies du réseau 404 comme illustré sur la figure 6G. Les saillies 407 sont alors formées de premiers tronçons 408 dans le silicium du film 403 et de seconds tronçons 403 dans la couche d'arrêt 502. Il est possible, comme cela a été expliqué de poursuivre la gravure dans la base 501 du second substrat intermédiaire 500 comme décrit à la figure 5H pour obtenir des troisièmes tronçons (non représentés) puis de supprimer les premiers tronçons et éventuellement les seconds tronçons.

## Revendications

1. Procédé d'élaboration de nanostructures comportant :
- une étape de fourniture d'un substrat (100) présentant une couche d'arrêt (2) enterrée et au-dessus de cette couche d'arrêt (2) un film cristallin (5) doté d'un réseau de défauts cristallins et/ou de champs de contraintes (12) dans une zone cristalline (13),
- une ou plusieurs étapes d'attaque du substrat (100), dont une attaque préférentielle soit des défauts cristallins et/ou des champs de contraintes, soit de la zone cristalline (13) entre les défauts cristallins et/ou les champs de contraintes, ces étapes d'attaque permettant de mettre à nu localement la couche d'arrêt (2) et de réaliser des saillies (7) à l'échelle nanométrique, séparées les unes des autres par des creux (7.1) ayant un fond situé dans la couche d'arrêt, les saillies conduisant aux nanostructures (7, 8).

2. Procédé selon la revendication 1, dans lequel le substrat est obtenu en effectuant :
- une étape de collage par adhésion moléculaire d'une face cristalline (1.1) d'un premier substrat intermédiaire (1) et d'une face cristalline (1.2 d'un second substrat intermédiaire (4), ce premier substrat intermédiaire (1) comportant la couche d'arrêt (2) placée sous le film, (3), la face cristalline (1.1) du premier substrat intermédiaire (1) étant celle du film (3), le collage étant fait de façon que les faces (1.1, 1.2) présentent des réseaux cristallins décalés, et que le réseau de défauts cristallins et/ou de champs de contraintes (12) se forme dans la zone cristalline (13) au voisinage de l'interface,
- une étape d'amincissement du second substrat intermédiaire (4).

3. Procédé selon la revendication 1, dans lequel le substrat (100) est obtenu en effectuant un report, sur un substrat intermédiaire (500) doté de la couche d'arrêt (502), d'un film cristallin (403) comportant un tel réseau de défauts cristallins et/ou de champs de contraintes (404).

4. Procédé d'élaboration de nanostructures selon l'une des revendications 1 à 3, **caractérisé en ce que**, les saillies (7) matérialisent les nanostructures.

5. Procédé d'élaboration de nanostructures, selon l'une des revendications 1 à 3, **caractérisé en ce qu'**il consiste à effectuer un traitement complémentaire visant à graver au moins la couche d'arrêt (2) du substrat (100), les saillies (7) servant de masque, les nanostructures (8) étant matérialisées au moins par des tronçons (9) à l'aplomb des saillies, gravés dans la couche d'arrêt (2) du substrat (100), obtenus lors du traitement complémentaire.

6. Procédé d'élaboration de nanostructures selon la revendication 5, **caractérisé en ce qu'**il consiste à recouvrir les saillies d'un matériau (316) apte à renforcer la résistance des saillies (7) lors du traitement complémentaire.

7. Procédé selon l'une des revendications 5 ou 6, dans lequel le substrat (100) comporte une base (10) sous-jacente à la couche d'arrêt (2), **caractérisé en ce que** la gravure du traitement complémentaire est arrêtée par la base (10).

8. Procédé selon la revendication 7, **caractérisé en ce qu'**il consiste à effectuer de plus un traitement supplémentaire visant à graver la base (10) du substrat (100), les tronçons (9) dans la couche d'arrêt (2) du substrat (100) et/ou les saillies (7) servant de masque, les nanostructures (8) étant matérialisées au moins par des tronçons (11), à l'aplomb des tronçons (9) dans la couche d'arrêt (2), gravés dans la base (10), obtenus lors du traitement supplémentaire.

9. Procédé selon la revendication 7, dans lequel une couche additionnelle (16) est insérée entre la base (10) et la couche d'arrêt (2) du substrat (100), **caractérisé en ce qu'**il consiste à effectuer, de plus, un traitement additionnel visant à graver la couche additionnelle (16), les tronçons (9) dans la couche d'arrêt (2) et/ou les saillies servant de masque, les nanostructures (8) étant matérialisées au moins par des tronçons (11.1) à l'aplomb des tronçons (9) dans la couche d'arrêt (2), gravés dans la couche additionnelle (16), obtenus lors du traitement additionnel.

10. Procédé selon la revendication 9, **caractérisé en ce que** la gravure du traitement additionnel est arrêtée par la base (10) du substrat (100).

11. Procédé selon la revendication 10, **caractérisé en ce que** la base du substrat est multicouche et comporte une couche d'arrêt (302) sous-jacente à la couche additionnelle (303).

12. Procédé selon l'une des revendications 5 à 11, **caractérisé en ce qu'**il comporte une étape d'élimination des saillies (7).

13. Procédé selon l'une des revendications 8 ou 9, **caractérisé en ce qu'**il comporte une étape d'élimination des tronçons (9) gravés dans la couche d'arrêt (2) du substrat (100).

14. Procédé selon l'une des revendications 6 à 10, **caractérisé en ce que** la couche additionnelle (16) est réalisée en matériau semi-conducteur cristallin.

15. Procédé selon l'une des revendications 1 à 14, **caractérisé en ce que** les attaques et/ou le traitement complémentaire et/ou le traitement supplémentaire et/ou le traitement additionnel sont choisis parmi la gravure sèche ou humide, chimique, ionique, électrochimique, photochimique, thermique, sous atmosphère oxydante ou réductrice.

16. Procédé selon la revendication 15, **caractérisé en ce qu'**au moins une étape d'attaque ou de traitement est une gravure anisotrope visant à facetter les nanostructures (8).

17. Procédé selon l'une des revendications 15 ou 16, **caractérisé en ce qu'**au moins une étape d'attaque ou de traitement a une vitesse d'attaque différente selon le matériau mis en jeu.

18. Procédé selon la revendication 15, **caractérisé en ce qu'**au moins une étape d'attaque ou de traitement est une gravure anisotrope visant à reporter le relief des saillies (7) déjà créées.

19. Procédé selon l'une des revendications 2 à 18, **caractérisé en ce qu'**il consiste à utiliser en tant que premier substrat intermédiaire et en tant que second substrat intermédiaire des substrats semi-conducteur sur isolant (212, 210) ayant chacun un film semi-conducteur (207, 213) prélevé dans un même bloc (20) de matériau semi-conducteur cristallin, les faces cristallines des substrats intermédiaires étant celles des films (207, 213).

20. Procédé selon la revendication 19, **caractérisé en ce que** le prélèvement se fait pour l'un des substrats semi-conducteur sur isolant (210):
- en formant une couche d'oxyde (202) en surface du bloc (20),
- en créant une zone fragilisée (204) au sein du bloc (20) sous la couche d'oxyde (202) par implantation ionique,
- en assemblant le bloc (20) par sa couche d'oxyde (202) à un substrat auxiliaire (206),
- en provoquant une fracture au niveau de la zone fragilisée (204), le matériau se trouvant entre la couche d'oxyde (202) et la zone fragilisée (204) formant le film (207) du substrat, le reste du bloc (20) formant un élément restant (208).

21. Procédé selon la revendication 20, **caractérisé en ce que** le prélèvement se fait pour l'autre substrat semi-conducteur sur isolant (212):
- en formant une couche d'oxyde (209) en surface de l'élément restant (208),
- en créant une autre zone fragilisée (211) au sein de l'élément restant (208) sous la couche d'oxyde (209) par implantation ionique,
- en assemblant l'élément restant (208) par sa couche d'oxyde (209) à un autre substrat auxiliaire (216),
- en provoquant une fracture au niveau de l'autre zone fragilisée (211), le matériau se trouvant entre la couche d'oxyde (209) et l'autre zone fragilisée (211) formant le film (213) de l'autre substrat semi-conducteur sur isolant (212).

22. Procédé selon la revendication 21, **caractérisé en ce qu'**il consiste à graver des marques de repérage (205) dans le bloc (20) avant son assemblage au substrat auxiliaire, ces marques de repérage (205) s'étendant au-delà de la zone fragilisée (204) jusqu'à atteindre l'autre zone fragilisée (211), ces marques facilitant le décalage des réseaux cristallins.

23. Procédé selon la revendication 22, **caractérisé en ce qu'**il consiste à faire tourner l'une des faces de 180° par rapport à l'autre, à l'aide des marques de repérage (205), avant d'introduire le décalage des réseaux cristallins.

24. Procédé selon l'une des revendications 19 à 21, dans lequel le premier substrat semi-conducteur sur isolant (310) est un substrat semi-conducteur sur isolant double, son substrat auxiliaire (300) étant un substrat semi-conducteur sur isolant avec une couche isolante (302), insérée entre une couche (301) et un film (303) en matériau semi-conducteur, **caractérisé en ce qu'**il consiste à assembler le film (303) du substrat auxiliaire (300) à la couche d'oxyde (202).

## Claims

1. Method for producing nanostructures comprising:
- a step of providing a substrate (100) having a buried barrier layer (2) and above said barrier layer (2) a crystalline film (5) provided with a network of crystalline defects and/or stress fields (12) in a crystalline zone (13),
- one or several steps of attacking the substrate (100), of which a preferential attack either of the crystalline defects and/or stress fields, or of the crystalline zone (13) between the crystalline defects and/or the stress fields, said attack steps enabling the barrier layer (2) to be laid bare locally and protrusions (7) to be formed on a nanometric scale, separated from each other by hollows (7,1) having a base located in the barrier layer, the protrusions leading to the nanostructures (7, 8).

2. Method according to claim 1, in which the substrate is obtained by carrying out:
- a step of bonding by molecular adhesion a crystalline face (1.1) of a first intermediate substrate (1) and a crystalline face (1.2) of a second intermediate substrate (4), said first intermediate substrate (1) comprising the barrier layer (2) placed under the film, (3), the crystalline face (1.1) of the first intermediate substrate (1) being that of the film (3), the bonding being carried out in such a way that the faces (1.1, 1.2) have offset crystalline networks, and that the network of crystalline defects and/or stress fields (12) forms in the crystalline zone (13) in the vicinity of the interface,
- a step of thinning the second intermediate substrate (4).

3. Method according to claim 1, in which the substrate (100) is obtained by carrying out a transfer, onto an intermediate substrate (500) provided with the barrier layer (502), of a crystalline film (403) comprising such a network of crystalline defects and/or stress fields (404).

4. Method for producing nanostructures according to one of claims 1 to 3, **characterised in that** the protrusions (7) materialise the nanostructures.

5. Method for producing nanostructures, according to one of claims 1 to 3, **characterised in that** it consists in carrying out a complementary treatment aiming to etch at least the barrier layer (2) of the substrate (100), the protrusions (7) serving as mask, the nanostructures (8) being materialised at least by segments (9) directly in line with the protrusions, etched in the barrier layer (2) of the substrate (100), obtained during the complementary treatment.

6. Method for producing nanostructures according to claim 5, **characterised in that** it consists in covering the protrusions with a material (316) capable of reinforcing the resistance of the protrusions (7) during the complementary treatment.

7. Method according to one of claims 5 or 6, in which the substrate (100) comprises a base (10) underlying the barrier layer (2), **characterised in that** the etching of the complementary treatment is stopped by the base (10).

8. Method according to claim 7, **characterised in that** it consists in carrying out in addition a supplementary treatment aiming to etch the base (10) of the substrate (100), the segments (9) in the barrier layer (2) of the substrate (100) and/or the protrusions (7) serving as mask, the nanostructures (8) being materialised at least by segments (11), directly in line with segments (9) in the barrier layer (2), etched in the base (10), obtained during the supplementary treatment.

9. Method according to claim 7, in which an additional layer (16) is inserted between the base (10) and the barrier layer (2) of the substrate (100), **characterised in that** it consists in carrying out, in addition, an additional treatment aiming to etch the additional layer (16), the segments (9) in the barrier layer (2) and/or the protrusions serving as mask, the nanostructures (8) being materialised at least by segments (11.1) directly in line with segments (9) in the barrier layer (2), etched in the additional layer (16), obtained during the additional treatment.

10. Method according to claim 9, **characterised in that** the etching of the additional treatment is stopped by the base (10) of the substrate (100).

11. Method according to claim 10, **characterised in that** the base of the substrate is multilayer and comprises a barrier layer (302) underlying the additional layer (303).

12. Method according to one of claims 5 to 11, **characterised in that** it comprises a step of eliminating the protrusions (7).

13. Method according to one of claims 8 or 9, **characterised in that** it comprises a step of eliminating the segments (9) etched in the barrier layer (2) of the substrate (100).

14. Method according to one of claims 6 to 10, **characterised in that** the additional layer (16) is formed in crystalline semi-conductor material.

15. Method according to one of claims 1 to 14, **characterised in that** the attacks and/or the complementary treatment and/or the supplementary treatment and/or the additional treatment are chosen among dry or wet, chemical, ionic, electrochemical, photochemical or thermal etching, under oxidising or reducing atmosphere.

16. Method according to claim 15, **characterised in that** at least one attack or treatment step is an anisotropic etching aiming to facet the nanostructures (8).

17. Method according to one of claims 15 or 16, **characterised in that** at least one attack or treatment step has a different rate of attack depending on the material brought into play.

18. Method according to claim 15, **characterised in that** at least one attack or treatment step is an anisotropic etching aiming to transfer the relief of the protrusions (7) already created.

19. Method according to one of claims 2 to 18, **characterised in that** it consists in using as first intermediate substrate and as second intermediate substrate semi-conductor on insulator substrates (212, 210) each having a semi-conductor film (207, 213) removed from a same block (20) of crystalline semi-conductor material, the crystalline faces of the intermediate substrates being those of films (207, 213).

20. Method according to claim 19, **characterised in that** the removal is carried out for one of the semi-conductor on insulator substrates (210):
- by forming an oxide layer (202) on the surface of the block (20),
- by creating an embrittled zone (204) within the block (20) under the layer of oxide (202) by ion implantation,
- by assembling the block (20) by its layer of oxide (202) to an auxiliary substrate (206),
- by provoking a fracture at the level of the embrittled zone (204), the material found between the layer of oxide (202) and the embrittled zone (204) forming the film (207) of the substrate, the remainder of the block (20) forming a remaining element (208).

21. Method according to claim 20, **characterised in that** the removal is carried out for the other semi-conductor on insulator substrate (212):
- by forming an oxide layer (209) at the surface of the remaining element (208),
- by creating another embrittled zone (211) within the remaining element (208) under the layer of oxide (209) by ion implantation,
- by assembling the remaining element (208) by its layer of oxide (209) to another auxiliary substrate (216),
- by provoking a fracture at the level of the other embrittled zone (211), the material found between the layer of oxide (209) and the other embrittled zone (211) forming the film (213) of the other semi-conductor on insulator substrate (212).

22. Method according to claim 21, **characterised in that** it consists in etching locating marks (205) in the block (20) before its assembly to the auxiliary substrate, said locating marks (205) extending beyond the embrittled zone (204) until reaching the other embrittled zone (211), said marks facilitating the offset of the crystalline networks.

23. Method according to claim 22, **characterised in that** it consists in turning one of the faces 180° in relation to the other, by means of locating marks (205), before introducing the offset of the crystalline networks.

24. Method according to one of claims 19 to 21, in which the first semi-conductor on insulator substrate (310) is a double semi-conductor on insulator substrate, its auxiliary substrate (300) being a semi-conductor on insulator substrate with an insulator layer (302), inserted between a layer (301) and a film (303) in semi-conductor material, **characterised in that** it consists in assembling the film (303) of the auxiliary substrate (300) to the layer of oxide (202).

## Patentansprüche

1. Verfahren zum Aufbau von Nanostrukturen, umfassend:
- einen Schritt des Bereitstellens eines Substrats 100, das eine überdeckte Barriereschicht (2) und auf dieser Barriereschicht (2) einen kristallinen Film (5) aufweist, ausgestattet mit einer Anordnung von kristallinen Fehlstellen und/oder Spannungsfeldern (12) in einer kristallinen Zone (13),
- einen oder mehrere Angriffschritte auf das Substrat (100), wobei ein Angriff vorzugsweise entweder auf kristalline Fehlstellen und/oder Spannungsfelder erfolgt, oder auf die kristalline Zone (13) zwischen den kristallinen Fehlstellen und/oder den Spannungsfeldern, wobei diese Angriffisschritte es erlauben lokal die Barriereschicht (2) freizulegen und Erhöhungen bzw. Buckel (7) im Nano-Maßstab aufzubauen, wobei sie voneinander getrennt sind durch die Vertiefungen (7.1), die einen Boden aufweisen, der in der Barriereschicht angeordnet ist, wobei die Erhöhungen zu Nanostrukturen (7, 8) führen

2. Verfahren nach Anspruch 1, worin das Substrat erhalten wird durch Ausführen:
eines Schrittes des Verklebens durch molekulare Adhäsion einer kristallinen Oberfläche (1.1) eines ersten intermediären Substrats (1) und einer kristallinen Oberfläche (1.2) eines zweiten intermediären Substrats (4), wobei das erste intermediäre Substrat (1) die Barriereschicht (2) umfasst, die unter dem Film (3) angeordnet ist, wobei die kristalline Oberfläche (1.1) des ersten intermediären Substrats (1) diejenige des Films (3) ist, wobei das Verkleben so erfolgt, dass die Oberflächen (1.1, 1.2) versetzte kristalline Anordnungen darstellen und dass die Anordnung von kristallinen Fehlstellen und/oder Spannungsfeldern (12) sich in der kristallinen Zone (13) in der Umgebung der Grenzfläche bildet,
- einen Schritt der Verjüngung des zweiten intermediären Substrats (4).

3. Verfahren nach Anspruch 1, worin das Substrat (100) erhalten wird durch Durchführen einer Übertragung, auf ein intermediäres Substrat (500), ausgestattet mit der Barriereschicht (502), eines kristallinen Films (403), der eine solche Anordnung kristalliner Fehlstellen und/oder Spannungsfelder (404) umfasst.

4. Verfahren zum Aufbau von Nanostrukturen nach einem der Ansprüche 1 bis 3, **dadurch gekennzeichnet, dass** die Erhöhungrn (7) Nanostrukturen darstellen.

5. Verfahren zum Aufbau von Nanostrukturen nach einem der Ansprüche 1 bis 3, **dadurch gekennzeichnet, dass** es darin besteht eine komplementäre Behandlung durchzuführen, die darauf gerichtet ist mindestens die Barriereschicht (2) des Substrats (100) zu gravieren, wobei die Erhöhungen (7) als Maske dienen, wobei die Nanostrukturen (8) zumindest durch die Abschnitte (9) rechtwinklig zu den Erhöhungen realisiert werden, die eingraviert sind in die Barriereschicht (2) des Substrats (100), erhalten durch die komplementäre Behandlung.

6. Verfahren zum Aufbau von Nanostrukturen nach Anspruch 5, **dadurch gekennzeichnet, dass** es darin besteht die Erhöhungen zu beschichten mit einem Material (316), um die Beständigkeit der Erhöhungen (7) während der komplementären Behandlung zu verbessern.

7. Verfahren zum Aufbau von Nanostrukturen nach einem der Ansprüche 5 oder 6, worin das Substrat (100) eine Basis (10) umfasst, die unter der Barriereschicht (2) liegt, **dadurch gekennzeichnet, dass** die Gravur der komplementären Behandlung an der Basis (10) angehalten wird.

8. Verfahren nach Anspruch 7, **dadurch gekennzeichnet, dass** es die Durchführung einer ergänzenden Behandlung umfasst, die darauf gerichtet ist die Basis (10) des Substrats (100) zu gravieren, wobei die Abschnitte (9) in der Barriereschicht (2) des Substrats (100) und/oder die Erhöhungen (7) als Maske dienen, wobei die Nanostrukturen (8) zumindest durch die Abschnitte (11), rechtwinklig zu den Abschnitten (9) in der Barriereschicht (2), realisiert werden, eingraviert in die Basis (10), erhalten während der zusätzlichen Behandlung.

9. Verfahren nach Anspruch 7, worin eine zusätzliche Schicht (16) zwischen der Basis (10) und der Barriereschicht (2) des Substrats (100) eingebaut wird, **dadurch gekennzeichnet, dass** es weiterhin die Durchführung einer ergänzenden Behandlung umfasst, die darauf gerichtet ist die zusätzliche Schicht (16) zu gravieren, wobei die Abschnitte (9) in der Barriereschicht (2) und/oder die Erhöhungen als Maske dienen, wobei die Nanostrukturen (8) zumindest durch die Abschnitte (11,1), rechtwinklig zu den Abschnitten (9) in der Barriereschicht (2), realisiert werden, eingraviert in die zusätzliche Schicht (16), erhalten während der zusätzlichen Behandlung.

10. Verfahren nach Anspruch 9, **dadurch gekennzeichnet, dass** die zusätzliche Gravurbehandlung an der Basis (10) des Substrats (100) angehalten wird.

11. Verfahren nach Anspruch 10, **dadurch gekennzeichnet, dass** die Basis des Substrats mehrschichtig ist und eine Barriereschicht (302) umfasst, die unter der zusätzlichen Schicht (303) liegt.

12. Verfahren nach einem der Ansprüche 5 bis 11, **dadurch gekennzeichnet, dass** es einen Schritt der Beseitigung von Erhöhungen Buckeln (7) umfasst.

13. Verfahren nach einem der Ansprüche 8 oder 9, **dadurch gekennzeichnet, dass** es einen Schritt der Beseitigung von Abschnitten (9), die in die Barriereschicht (2) des Substrats (100) graviert sind, umfasst.

14. Verfahren nach einem der Ansprüche 6 bis 10, **dadurch gekennzeichnet, dass** die zusätzliche Schicht (16) aus einem kristallinen Halbleitermaterial hergestellt wird.

15. Verfahren nach einem der Ansprüche 1 bis 14, **dadurch gekennzeichnet, dass** die Angriffe und/oder die komplementäre Behandlung und/oder die ergänzende Behandlung und/oder die zusätzliche Behandlung ausgewählt werden aus Trocken- oder Feuchtgravur, chemischer, ionischer, elektrochemischer, photochemischer, thermischer Gravur, unter oxidierender oder reduzierender Atmosphäre.

16. Verfahren nach Anspruch 15, **dadurch gekennzeichnet, dass** mindestens ein Angriffisschritt oder Behandlungsschritt eine anisotrope Gravur ist mit dem Ziel die Nanostrukturen (8) zu facettieren.

17. Verfahren nach einem der Ansprüche 15 oder 16, **dadurch gekennzeichnet dass** mindestens ein Angriffs- oder Behandlungsschritt eine Angriffsgeschwindigkeit hat, die entsprechend des betreffenden Materials verschieden ist.

18. Verfahren nach Anspruch 15, **dadurch gekennzeichnet, dass** mindestens ein Angriffs- oder Behandlungsschritt eine anisotrope Gravur ist, mit dem Ziel das Relief der bereits gebildeten Erhöhungen (7) zu übertragen.

19. Verfahren nach einem der Ansprüche 2 bis 18, **dadurch gekennzeichnet, dass** es die Verwendung als primäres intermediäres Substrat und als sekundäres intermediäres Substrat von Halbleitersubstraten auf Isolatoren (212, 210) umfasst, wobei jeder einen Halbleiterfilm (207, 213) aufweist, der aus einem gleichen Block (20) aus kristallinem Halbleitermaterial entnommen wird, wobei die kristallinen Oberflächen der intermediären Substrate bzw. Zwischensubstrate diejenigen der Filme (207, 213) sind.

20. Verfahren nach Anspruch 19, **dadurch gekennzeichnet, dass** die Entnahme eines der Halbleitersubstrate über dem Isolator (210) erfolgt:
- durch Bildung einer Oxidschicht (202) auf der Oberfläche des Blocks (20),
- durch Entwickeln einer empfindlichen Zone (204) im Block (20) unter der Oxidschicht (202) durch Ionenimplantation,
- durch Zusammenfügen des Blocks (20) über seine Oxidschicht (202) mit einem Hilfssubstrat (206),
- durch Hervorrufen eines Bruchs auf der Ebene der empfindlichen Zone (204), wobei sich das Material zwischen der Oxidschicht (202) und der empfindlichen Zone (204) befindet, wobei der Film (207) des Substrats gebildet wird, wobei der Rest des Blocks (20) ein restliches Element (208) bildet.

21. Verfahren nach Anspruch 20, **dadurch gekennzeichnet, dass** die Entnahme für das andere Halbleitersubstrat über dem Isolator (212) erfolgt:
- durch Bildung einer Oxidschicht (202) auf der Oberfläche des restlichen Elements (208),
- durch Entwickeln einer anderen empfindlichen Zone (211) im restlichen Element (208) unter der Oxidschicht (209) durch lonenimplantation,
- durch Zusammenfügen des restlichen Elements (208) über seine Oxidschicht (209) an ein anderes Hilfssubstrat (216),
- durch Hervorrufen eines Bruchs auf der Ebene der anderen empfindlichen Zone (211), wobei sich das Material zwischen der Oxidschicht (209) und der anderen empfindlichen Zone (211) befindet, wobei der Film (213) des anderen Halbleitersubstrats über dem Isolator (212) gebildet wird.

22. Verfahren nach Anspruch 21, **dadurch gekennzeichnet, dass** es das Gravieren von Markierungsmarken (205) in den Block (20) umfasst, vor seinem Zusammenbau auf dem Hilfssubstrat, wobei die Markierungsmarken (205) sich von der empfindlichen Zone (204) bis zur anderen empfindlichen Zone (211) darüberhinaus erstrecken, wobei die Markierungen die Versetzung der kristallinen Anordnung erleichtern.

23. Verfahren nach Anspruch 22, **dadurch gekennzeichnet, dass** es das Drehen einer der Oberflächen um 180 ° bezüglich der anderen umfasst, mit Hilfe von Markierungsmarken (205), vor Einleiten der Versetzung der kristallinen Anordnung.

24. Verfahren nach einem der Absprüche 19 bis 21, worin das erste Halbleitersubstrat auf dem Isolator (310) ein Halbleitersubstrat auf einem Doppel-Isolator ist, sein Hilfssubstrat (300) ein Halbleitersubstrat auf einem Isolator mit einer Isolationsschicht (302) ist, eingebaut zwischen einer Schicht (301) und einem Film (303) aus Halbleitermaterial, **dadurch gekennzeichnet, dass** es den Aufbau des Films (303) des Hilfssubstrats (300) an der Oxidschicht (202) umfasst.
